# EUROPEAN PATENT APPLICATION

(11) **EP 4 607 066 A1**
(43) Date of publication of application: **27.08.2025**
(21) Application number: 24158909.2
(22) Date of filing: 21.02.2024
(51) Int. Cl.: F16J 15/06, F16J 15/10, F16L 23/22, H02G 5/06

(54) **FLAT COMPRESSION SEALING GASKET AND SEALING SYSTEM COMPRISING SAME**

(71) Applicant: General Electric Technology GmbH, 5400 Baden (CH)
(72) Inventor: MUELLER, Christoph, 69100 Villeurbanne, Rhône (FR); CHAREYRON, Vincent, 69100 Villeurbanne, Rhône (FR)
(74) Representative: Rüger Abel Patentanwälte PartGmbB

(57) **Abstract**

A compression sealing gasket (2) and a sealing system (1) of a gas-insulated portion of a high or medium voltage apparatus are disclosed. The sealing system (1) comprises two components (3, 4) fastened together, wherein each of the components (3, 4) comprises an assembly face (12, 13) that faces the assembly face (13, 12) of the other component (4, 3), and a compression sealing gasket (2) that is arranged and compressed axially between the assembly faces (12, 13) of the components (3, 4). The compression sealing gasket (2) comprises a ring-shaped, preferably annular main body (22) made of an elastomer material and having a main axis (A). The main body (22) has a generally flat planar configuration that extends perpendicular to the main axis (A) and comprises a radially outer side (23), a radially inner side (24) and end faces (26, 27) which delimit the main body (22) along the main axis (A) and connect the inner side (24) and the outer side (23). The gasket (2) further comprises a lip (28) projecting from the main body (22) outwards in axial direction parallel to the main axis (A) beyond one of the end faces (26, 27). The lip (28) is arranged in a distance to both the inner side (24) and the outer side (23) of the main body (22) and engages a ring-shaped fixation groove (21) formed in an assembly face (12, 13) of one of the components (3, 4). The fixation groove (21) receives the lip (28) of the gasket (2, 2', 2") with slight compression, thereby preventing movement or displacement of the gasket (2, 2', 2") during operation.

## Description

### Technical field

The present invention relates to a compression sealing gasket designed to reduce its permeability to gas and to facilitate its mounting and a sealing system of a gas-insulated portion of a high or medium voltage apparatus comprising such a compression sealing gasket at the connection between two components of the gas-insulated apparatus.

### Background of the invention

Some high or medium voltage apparatuses comprise hollow components in which conductors are arranged. An insulating gas fills these components to isolate the conductors carrying current at a high voltage from the hollow components which are at ground potential. The insulating gas is able to withstand the dielectric field even in short distances between the conductors arranged in the components. The insulating gas may be under pressure of at least 1 bar or several bars. Such gas-insulated apparatuses may include gas-insulated switches, circuit-breakers, disconnectors, transformers, surge arresters or gas-insulated substations or lines, for example.

The connection between the two components of the gas-insulated apparatuses may, for example, comprise a cylindrical or tubular part from each component and a sealing gasket placed between the cylindrical or tubular parts to prevent the insulating gas contained in the interior of the apparatus to escape to the outside or to prevent that other gases in the outside atmosphere, for example, water vapor, may penetrate into the inside and mix with the insulating gas due to a higher partial pressure in the atmosphere compared to the inside of the cylindrical or tubular part.

According to a known implementation, the sealing gasket is made of an elastomer and is compressed between tightened components of the gas-containing apparatus, e.g. two tubular parts or a tubular part and a cover plate. The compression of the elastomeric gasket by the components produces an elastic deformation of the gasket filling all gaps or roughness of the tubular part on both sides and thus closing or blocking all direct ways for the inside and outside gas to go from the inside to the outside or vice versa. The elasticity of the material leads to an improved tightness of the connection.

However, gaskets generally made of elastomer show a permeability to all gases and in particular to insulating gases which are often under high pressure. While leakage of an insulating gas around the gasket through imperfectly closed roughness may be substantially effectively prevented by the sealing gasket compressed between the two components, a process of molecular penetration of the gas through the elastomeric material of the sealing gasket may occur, the process referred to as permeation.

It is desired to provide a sealing gasket having a significantly lower permeability to the insulating gases, in order to reduce the leakage rate for a complete apparatus. For the intended applications, the aim is to reach for the entire arrangement a leakage rate less than 0.5% vol/year, as described in the relevant IEC standards for switchgears, for example IEC 62271-203 for gas-insulated switchgears.

This aim is of particular interest, since the industry moves towards insulating gases, consisting of gases or gas mixtures, that may leak differently due to different characteristics of the molecules of the new gases used compared to the prevailing SF₆ gas that has been used for decades, but is a powerful greenhouse gas.

In particular, a switching and insulating gas called "g3" comprising heptafluoroisobutyronitrile mixed with a dilution gas comprising carbon dioxide and oxygen is increasingly being used as a replacement for the SF₆ gas. But CO₂ has a strong propensity to leak. O₂ and N₂ also leak, although less than CO₂. These three gases have a higher susceptibility to leak than SF₆. The leaks pose problems because of the adverse effect of CO₂ on the environment. The lost gas must also be replaced, which involves further costs associated with necessary maintenance operations.

WO 2022/152811 A1 discloses a sealing system comprising two cylindrical components arranged coaxially to each other and to a main axis. Each of the components comprises an end face extending in a plane perpendicular to the main axis, that faces the end face of the other component. A compression sealing gasket is arranged and is compressed axially between the end faces of the cylindrical components. The compression sealing gasket comprises an annular main body made of an elastomer material and having the main axis, the main body comprising an annular radially outer face and an annular radially inner face parallel and coaxial to each other and annular end faces that are wavy shaped to enhance the sealing performance when the gasket is compressed between the cylindrical components. The gasket further comprises an insert mounted on the radially inner face of the gasket and arranged to reduce the section through which the gas contained in the interior of the components can migrate. The insert is made of a material that has a significant lower permeability than the elastomeric main body material.

While the known compression sealing gasket may provide an improved sealing performance and significantly lower permeability of the gasket reducing the leakage rate for the gas-insulated apparatus, the combination of the main body and the insert made of different materials and assembled together makes the compression sealing gasket rather complex and costly. It would be desired to reduce the complexity of a compression sealing gasket while ensuring the same level of tightness.

Another problem encountered with such compression sealing gaskets is that a recess is normally required in at least one of the assembly faces of the components of the apparatus to receive at least a part of the gasket. The recess(es) must be precisely formed such that the gasket may perfectly fit therein and is not displaced during assembly and in operation. A displacement may occur accidentally during assembly or may be caused during operation by vibrations of the apparatus or the internal pressure of the gas contained in the apparatus, which may be up to 20 bar. A displacement of the gasket can result in increased gas leakage and early failure of the apparatus, requiring inadvertent premature servicing. A displacement of the gasket and associated gas leakage must be prevented in any operating position of the gasket, regardless of whether it is mounted vertically, horizontally or in another position.

On the other hand, sufficient clearance must also be provided in the receiving groove for the compression sealing gasket to allow expansion of the gasket as a result of the compression of the gasket between the assembly faces of the components and to also make thermal expansion and contraction possible without affecting the sealing performance. Still further, a receiving groove for the gasket is not absolutely necessary. The gasket may be readily received and compressed between spaced flat assembly faces of the components. In all these cases, it would be desired to provide for efficient sealing while preventing the gasket from being displaced during assembly and operation.

It is, therefore, an object of the present invention to provide a low permeability compression sealing gasket to reduce the gas leakage rate for a complete apparatus while effectively preventing the compression sealing gasket from being displaced during assembly and/or operation.

In particular, it is an object of the present invention to provide such an improved sealing gasket with low permeability to the gases of the types mentioned above and in particular in gas-insulated apparatuses of the types mentioned above, especially in high voltage or medium voltage components, like disconnectors, switches, circuit breakers, gas-insulated lines and the like, which are implemented in medium or high voltage applications, and including means for securely fixing the compression sealing gasket in place to facilitate mounting and use of the gasket in any desired mounting and/or operating position.

Another object of the present invention is to provide a sealing system, in particular for gas-insulated high voltage or medium voltage apparatuses, comprising such an improved, easy-to-assemble and use sealing gasket.

### Brief description of the invention

In order to solve the above-mentioned object and remove at least some of the above-mentioned deficiencies, according to a first aspect of the invention, a compression sealing gasket is provided. The gasket comprises a ring-shaped main body made of an elastomer material and having a main axis, the main body having a generally flat planar configuration that extends perpendicular to the main axis and comprising a radially outer side, a radially inner side, and end faces which delimit the main body along the main axis and connect the inner side and the outer side. The gasket further comprises a lip projecting from the main body in axial direction parallel to the main axis beyond one of the end faces, the lip arranged in a distance to both the inner side and the outer side of the main body.

The invention provides a compression sealing gasket with an improved sealing design showing a low permeability to gases and reducing the leaking rate for a gas-insulated apparatus. With the generally flat planar configuration of the main body, the gasket may be made sufficiently long and thin to offer only a small surface area for the insulating gas to penetrate or to be absorbed by the gasket material and to effectively damp gas permeation in the radial direction, i.e., the length direction of the main body. Permeation, that is the process of penetration of molecule of a gas through the gasket by diffusion, is linked to the surface area under pressure. Due to the small thickness in the axial direction, the gasket offers a very small surface area for the inside gas to be absorbed and to permeate through the gasket material to the outside and to be desorbed to the atmosphere.

The gasket according to the invention may thus be very tight and efficient against leaks of insulating gases used or to be used in the gas-containing high voltage or medium voltage apparatuses, like disconnectors, or switches, or circuit breakers, or gas-insulated lines or substations, implemented in medium or high voltage applications. As the insulating gas, SF₆ or g3 gases, alone or mixed with O₂, CO₂ and/or N₂ or any other appropriate gases may be used, and the gases may be under pressure comprised between 1 bar and 20 bar, for example.

The lip in combination with the main body gives the sealing gasket a generally T-shaped configuration. The lip serves as a fixation lip to fix the gasket in an operating position to prevent movement or displacement or even falling out of the gasket during mounting and operation of the gasket even in case of high vibrations of the apparatus or a very high internal gas pressure directly acting on the gasket. The fixation lip may be arranged to engage a corresponding fixation groove in one of the components of the gas-insulated apparatus to prevent movement or displacement or falling out of the gasket during assembly in any mounting position like sideways or overhead or 'from the top' mounting. The small fixation lip can securely hold the gasket in place for horizontal, vertical, inclined or other orientations. The application of grease commonly used to fix or hold a normal O-ring type gasket in its position on one tubular part during mounting of the second tubular part is no longer needed as the lip maintains the gasket securely in its position in all imaginable ways of mounting including overhead gasket mounting. As no grease is needed during gasket mounting this invention offers a solution for low temperature applications where grease type mounting is forbidden due to the crystallization of grease and negative impact on the sealing performance. The small lip does not add much material to the main body of the gasket and does not noticeably increase complexity of the gasket and costs thereof. On the other hand, the lip provides the benefit of secure fixation of the gasket without the need for specific forms of receiving recesses in the components of the apparatus and without restricting the ability of the gasket to expand under compression or high temperature conditions.

In preferred embodiments of the gasket, the main body may have an annular or oval or ellipsoidal shape in a radial plane perpendicular to the main axis. Annular sealing gaskets are preferably used in the applications which are relevant here. They are very effective and enable easy handling. Other ring shapes of the gasket are also possible.

The main body of the gasket may preferably have a generally rectangular cross-section in an axial plane including the main axis. In some embodiments, the cross-section of the main body may be exactly rectangular, i.e. the radially outer and inner sides may be planar, parallel and coaxial to each other, and the end faces may also be substantially planar and run parallel to each other. In other embodiments, at least the radially outer and inner sides may taper and be convexly curved, for example, so as to reduce or eliminate contact pressure and loading in the end portions at the radially outer and inner sides. The radial end portions may then freely expand and contract as needed.

In some embodiments of any gasket mentioned above, the end faces, which delimit the main body in the axial direction, may have a convexly curved or wavy shape at least in a section thereof. Thus, during the lifetime of the gasket in service, regions of increased or high compression with increased contact pressure and enhanced sealing performance and regions of decreased or low compression and low contact pressure may be created. Low compression or low contact pressure zones may reduce the loading on the gasket in certain areas to avoid the risk of damage and negative ageing effects, e.g. tear or wear, of the ring-shaped or annular end faces and the lip, for example. Thus, convex regions or wave crests or elevations in the end faces may provide high compression zones which enhance the sealing performance, while regions of locally reduced material thickness of the main body or wave troughs in the end faces may enhance robustness, integrity and durability of the gasket.

In an advantageous embodiment, the main body may have a cross-sectional construction approximately in the middle or center of its planar extension in the radial direction. When the gasket is installed and compressed between components of the apparatus, this design results in a low compression or relief zone in the radial middle or center of the gasket, where also the fixation lip is preferably positioned, to avoid or at least reduce the risk of damage, e.g. tear, of the lip, while zones of higher compression or contact pressure in the portions between the cross-sectional construction and the radially inner and outer sides of the main body ensure sufficient leak tightness.

In preferred embodiments of any gasket mentioned above, the lip may be arranged approximately in the middle or center of the radial extension of the main body. The lip may extend as a complete ring over the entire circumference of the main body and may be closed within itself. This results in a simple and clear construction which facilitates stable fixation of the gasket in a respective ring-shaped fixation groove. As an alternative, the lip might also be segmented in the circumferential direction.

Preferably, the lip of the gasket of any embodiment mentioned above may be integrally formed, that is, formed in one piece with the main body and may be made of the same material as the main body. This facilitates manufacturing of the sealing gasket having the combination of the main body and the lip. The entire gasket may be preferably and advantageously produced in the same manufacturing process, e.g. by injection molding of a non-vulcanized (or uncured) elastomeric material in a mold, followed by compression and curing steps, for example.

Preferably, the entire gasket including the main body and the lip may be made of a single material, for example an elastomer like, but not limited thereto, unmodified butyl rubber or modified butyl rubber, e.g. chlorobutyl (CIIR) or bromobutyl (BIIR) rubber or halogenated butyl rubber (XIIR). Mixtures of these materials may also be used. The materials employed are low cost and particularly suitable for the intended sealing function and may reduce, although not completely avoid permeation of the gas through the material. The long and thin design of the gasket in combination with the materials employed ensures sufficient tightness.

In some embodiments of any above-mentioned gasket, the lip may comprise a rounded head and a connecting portion connecting the head to the main body. The connecting portion may have a width in a radial direction perpendicular to the main axis that is smaller than the corresponding width of the head to provide some flexibility to facilitate insertion of the lip into the corresponding fixation groove. The rounded head and the width of the head may be selected in combination with the dimensions of the fixation groove in the component of the apparatus such that the lip may contact flank surfaces of the fixation groove with a substantially linear contact to thereby provide a high contact pressure for improved sealing performance at the head.

An essential feature of the inventive gasket is the long and thin design of the main body. The main body may have a ratio of its length in the radial direction perpendicular to the main axis to its thickness in the axial direction parallel to the main axis such that the ratio is at least 5 or preferably at least 7 or most preferably approximately 8 to 12. Since the molecular permeation of the gas through the gasket by diffusion is a function of both the surface area under pressure and the diffusion length, the main body advantageously offers a reduced surface to permeation and an extended length to greatly reduce gas permeation.

In order to facilitate easy insertion of the lip into the fixation groove and secure retention of the gasket, the height of the lip in the axial direction may be greater than the thickness of the main body. Preferably, the height of the lip may be at least 1.5 times as great as the thickness of the main body.

The gasket of each of the aforementioned embodiments may have relatively large dimensions if required by the respective applications. For example, an inner dimension, e.g. the maximum inner diameter of an oval or ellipsoidal gasket or the inner diameter of an annular gasket, may be comprised between 40 mm or 100 mm and 500 mm or even 1300 mm. In preferred embodiments, it may be comprised between 100 mm and 300 mm and may be most preferably approximately 200 mm.

In order to solve the above-mentioned object and remove at least some of the deficiencies mentioned in the background of the invention above, according to another aspect of the invention, a sealing system of a gas-insulated portion of a high or medium voltage apparatus is provided. The sealing system comprises two components fastened together, wherein each of the components comprises an assembly face that faces the assembly face of the other component. The sealing system further comprises a compression sealing gasket according to any embodiment described above. The gasket is arranged and is compressed axially between the assembly faces of the cylindrical components.

The invention provides a sealing system that has a flat, substantially T-shaped ring-shaped, preferably annular gasket which is clamped and compressed between the assembly or sealing surfaces, which face each other, of the components of the apparatus, which are connected to one another, when the compression sealing gasket is installed. The sealing system may benefit from the advantages of each embodiment of the compression sealing gasket mentioned above.

In preferred embodiments, the two components of the apparatus may preferably be cylindrical and/or tubular and may be arranged coaxially to each other and to the main axis of the compression sealing gasket. The components may be fastened together using suitable fastening means, e.g. bolts and nuts, which facilitate adjusting the required or desired compression forces and pressures on the gasket.

In any sealing system mentioned above, at least one of the assembly faces of the components may comprise at least one recess, in which the compression sealing gasket may be located. However, in view of the fixation lip, a receiving groove for the main body of the gasket is not necessarily needed and may be omitted.

One of the assembly faces of the two components may comprise a ring-shaped, preferably annular fixation groove arranged to receive the lip of the gasket with slight compression in the radial direction perpendicular to the main axis. Preferably, a substantially linear compression contact between the rounded head of the lip and the associated inner flank surfaces of the fixation groove may be established.

In preferred embodiments of any above-mentioned sealing system, the main body may have, in the operating state of the gasket, an average compression rate comprised between 10% and 30%, preferably between 15% and 25%. Such an average compression rate may reduce both leakage of the gas around the main body and permeation therethrough. Advantageously, the average compression rate of the main body may be higher than the average compression rate of the lip.

In some embodiments, the gasket may be assembled with a small film of grease. A grease film may generally make the gasket easier to slide on and ensure a tight fit, may prevent tearing, cutting, crushing and abrasion of the elastomeric gasket, may prevent dirt from penetrating the surface of the components, may reduce the effort required to assemble the gasket and may prevent the gasket from moving. Due to the advantageous design of the gasket, including the fixation lip, only a small film of grease is needed, if any. In some embodiments, the gasket may be assembled without grease. A reduced amount of grease may lower the risk of crystallization of grease in low temperature applications, e.g. at -40° to -50°C, and may reduce the costs associated therewith.

In preferred embodiments of any sealing system mentioned above, the gas insulated portion of the high or medium voltage apparatus may form part of a gas-insulated switch, circuit breaker, disconnector, transformer, surge arrester, a gas-insulated substation or a gas-insulated line. The gas used in such apparatus may contain a gas comprising at least one of:
- an SF₆ gas;
- heptafluoroisobutyronitrile and/or heptafluoroisopropyl trifluoromethyl ketone (also named 2-butanone, 1,1,1,3,4,4,4-heptafluoro-3-(trifluoromethyl)- (CAS No 756-12-7)), possibly mixed with a gas or a dilution gas comprising at least CO₂ and/or O₂ and/or N₂ and/or an oxygenated compound; and
a gas comprising at least CO₂ and/or O₂ and/or N₂ and/or an oxygenated compound and/or water vapor.

The gas may be contained in the apparatus at a pressure between 1 bar and 20 bar, preferably between 5 bar or 15 bar.

Further details of advantageous embodiments of the present invention may be taken from the dependent claims, the drawings and the associated description.

### Brief description of the drawings

These and other features of the invention will be more readily understood from the following detailed description of various aspects of the invention taken in conjunction with the accompanying drawings that depict various exemplary embodiments of the invention which are not limiting in any way, wherein the same reference numbers are used in all figures to designate the same elements, and wherein:
Figure 1 shows a portion of a high voltage apparatus comprising two components assembled together using a compression sealing gasket according to a first embodiment of the invention, in a schematic partial cross-sectional view;
Figure 2a shows the compression sealing gasket of figure 1 in an isolated representation, in a perspective view;
Figure 2b shows the gasket of figures 1 and 2a in an enlarged partial cross-sectional view;
Figure 3 shows a portion of a high voltage apparatus comprising two components assembled together using a compression sealing gasket according to a second embodiment of the invention, in a schematic partial cross-sectional view, similar to figure 1;
Figure 4a shows a detail of the apparatus of figure 3 with the gasket in an uncompressed state, in a schematic partial cross-sectional view;
Figure 4b shows the detail of figure 4a with the gasket in a compressed state, in a schematic partial cross-sectional view, similar to figure 4a;
Figure 5a shows a portion of a high voltage apparatus comprising two components assembled together using a compression sealing gasket according to a third embodiment of the invention, with the gasket in an uncompressed state, in a schematic partial cross-sectional view; and
Figure 5b shows the portion of the apparatus of figure 5a with the gasket in a compressed state, in a schematic partial cross-sectional view.

### Detailed description

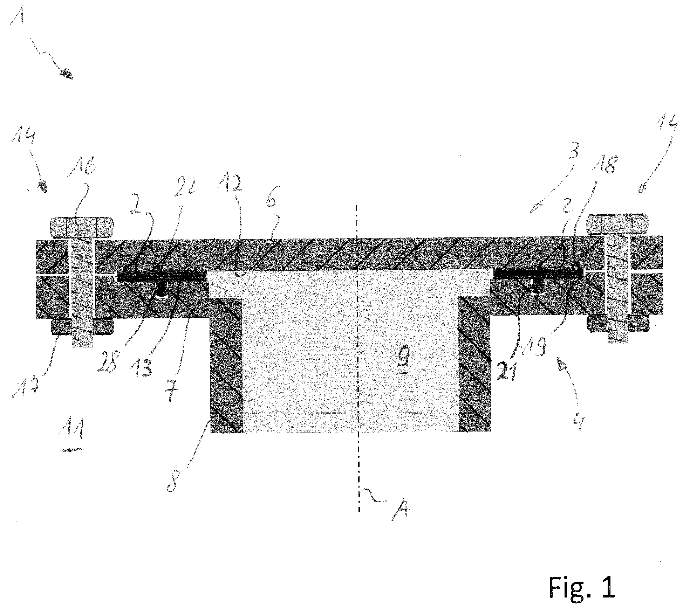

Figure 1 illustrates an example of a sealing system 1 according to the invention to which a compression sealing gasket 2 according to the invention can apply. In particular, the sealing system 1 includes a portion of a high or medium voltage apparatus comprising two components 3, 4 assembled together. In the illustrated example, the first component 3 is represented as a cylindrical cover 6 which is fastened to a cylindrical flange 7 of a tubular enclosure or housing 8 which forms the second component 4. Both components 3, 4 extend coaxially to a main axis A of the high voltage apparatus.

It should be understood that the two components 3, 4 may be of any other shape. For example, they may both be cylindrical or tubular or may also be non-cylindrical tubular parts which are assembled together and sealed using the gasket 2. The apparatus may be any gas-insulated medium or high voltage apparatus which includes electric and/or electronic devices and/or conductors which are insulated with gas. In the intended applications, the apparatus may be a gas-insulated switch, circuit-breaker, disconnector, transformer, surge arrester, a gas-insulated substation, a gas-insulated line, or the like.

The gas may comprise at least one of
- SF₆ gas;
- heptafluoroisobutyronitrile and/or heptafluoroisopropyl trifluoromethyl ketone (also named 2-butanone, 1,1,1,3,4,4,4-heptafluoro-3-(trifluoromethyl)- (CAS No 756-12-7)), possibly mixed with a gas or a dilution gas comprising at least CO₂ and/O₂ and/or N₂ and/or an oxygenated compound, and
- a gas comprising at least CO₂ and/or O₂ and/or N₂ and/or an oxygenated compound and/or water vapor.

The gas may be pressurized gas that may be contained in the apparatus at a pressure between 1 bar and 20 bar, for example, preferably between 5 bar or 15 bar. It is, therefore, necessary and desired to seal the connection between the components 3, 4 in a gastight manner to prevent the gas contained in the interior 9 of the apparatus to escape to the outside 11 of the apparatus. To this end, the sealing system 1 according to the invention is provided.

As can be seen in figure 1, the sealing system 1 generally includes at least parts of the components 3, 4 and the compression sealing gasket 2. The component 3 has an end face or assembly face 12 and the component 4 has an end face or assembly face 13 which faces the assembly face 12 of the component 3 and is connected thereto.

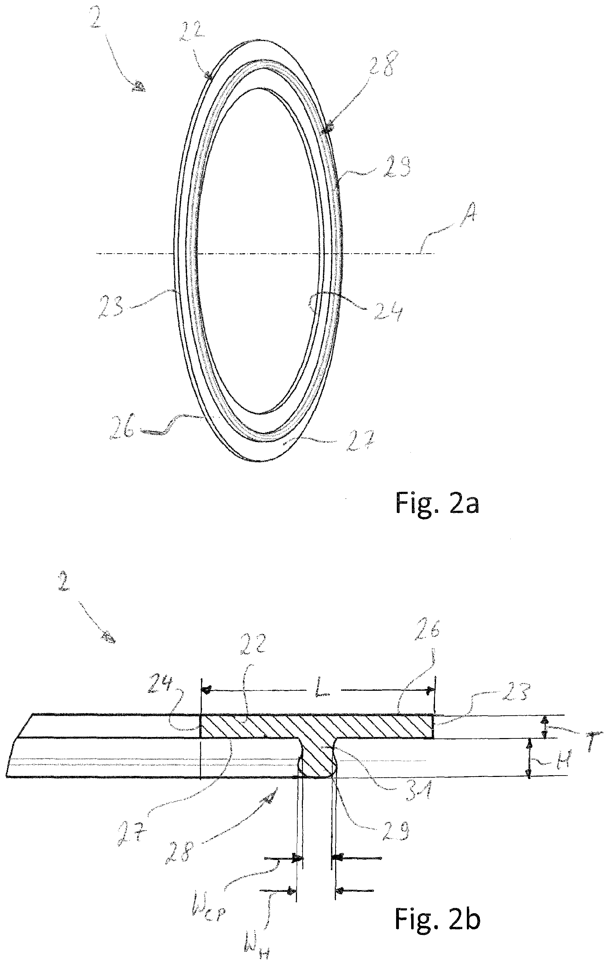

The sealing gasket 2 is arranged axially between the assembly faces 3, 4 of the two components 3, 4. The gasket 2 is substantially flat and extends substantially in a plane which is perpendicular to the main axis A. In the example shown, the sealing gasket 2 has an annular general shape and also has a circular symmetry around the axis A. Figure 2a shows a perspective view of the sealing gasket 2 according to the first embodiment of the invention. The sealing gasket 2 is discussed in more detail below.

The sealing system 1 further comprises tightening means 14, for example bolts 16 and nuts 17, or other bolting or clamping means that press the components 3, 4 axially towards each other and firmly hold the components 3, 4 fastened together. The tightening means 14 also compress axially the sealing gasket 2 to provide a gastight connection between the two components 3, 4.

In the embodiment represented in figures 1, 2a and 2b, the assembly faces 12, 13 of the components 3, 4 each comprise an annular recess 18, 19 for receiving at least a part of the sealing gasket 2. A first recess 18, in which a part of the gasket 2 is received, is formed as a cylindrical recess in the assembly face 12 of the gasket 2, while a second recess 19, in which another part of the gasket 2 is received, is formed as an annular recess opposite the first recess 18 in the assembly face 13 of the component 4.

The combined axial depth of the recesses 18, 19 is inferior to the axial height H of a main body 22 of the gasket 2, before the two components 3, 4 are assembled, said axial height H measured along the main axis A or along an axis perpendicular to the plane in which the gasket 2 extends.

In alternative embodiments, which include only one recess in one of the components 3, 4, whereas the other component is free of a recess and has a substantially planar assembly face, the axial depth of the single recess is inferior to the axial height H of the main body of the gasket 2 before the two components 3, 4 are assembled.

In further alternative embodiments not shown herein, both the first and second recesses 18, 19 may be omitted and the assembly faces 12, 13 of both the components 3, 4 may be formed as substantially planar surfaces. The gasket 2 may then be in contact with the assembly faces 12, 13 of both components 3, 4 and maintain the assembly faces 12, 13 spaced in a distance from each other. The radial sides of the gasket 2 will then not be flanked by any recessed portions of the assembly faces 12, 13.

In any case, one of the assembly faces 12, 13 comprises a fixation groove 21 formed therein to receive a fixation lip of the gasket 2 (described in more detail below) to fix the gasket 2 to the respective component. In the exemplary embodiment shown in figure 1, the fixation groove 21 is an annular groove formed in the assembly face 13 in the flange 7 of the component 4 and extending coaxially to the main axis A.

The compression of the gasket 2 by the tightening means 14 produces an axial deformation of the gasket 2 and maintains an efficient pressure of the gasket 2 on the assembly faces 12, 13 and against the walls and bottom of the recesses 18, 19 or the assembly faces 12, 13, respectively.

As can be seen in figure 1, and with further reference to figures 2a and 2b, the gasket 2 comprises the main body 22 that is made of an elastomer like, as non-limiting examples, unmodified butyl rubber or modified butyl rubber, for example chlorobutyl (CIIR) or bromobutyl (BIIR) rubber or halogenated butyl rubber (XIIR) or mixtures thereof. The material is cost-efficient and suitable for the intended sealing operation. However, it is still susceptible to gas permeation. That is, molecules of the gas may pass through the material of the gasket 2 by diffusion. The permeability of the elastomer with respect to the gas that fills the components 3, 4 results in a loss of gas over time.

As can be seen from figures 1, 2a, and 2b, the main body 22 has an annular shape which is circularly symmetrical about the axis A, which in the assembled state defines the main axis A of the portion of the apparatus shown in figure 1. It has a generally flat, planar shape that extends perpendicular to the main axis A. The main body 22 comprises a radially outer side 23 and a radially inner side 24 relative to the main axis A and end faces 26, 27 which delimit the main body 22 along the main axis A and connect the inner side 24 and the outer side 23. The outer and inner sides 23, 24 are substantially planar in the present exemplary embodiment and run parallel and coaxially to each other and to the main axis A. The end faces 26, 27 of the main body 22 are also substantially planar, thereby giving the main body 22 a generally rectangular cross-section in an axial plane including the main axis A, as shown in figures 1 and 2b. The first end face 26 is in contact with the assembly face 12 of the component 3 and the second end face 27 of the main body 22 is in contact with the assembly face 13 of the component 4.

It should be noted that, in alternative embodiments, the end faces 26, 27 may also be curved, e.g. convexly curved, or wavy shaped to influence the sealing performance of the gasket 2. As another alternative or in addition, the main body 22 may have a non-annular shape in a radial plane perpendicular to the main axis A, for example an oval or ellipsoidal shape or a rectangular, polygonal or irregular shape, depending on the application and requirements.

In order to fix the gasket 2 in the apparatus and avoid movement or displacement of the gasket 2 during operation, the gasket 2 further comprises a fixation lip 28 that projects from an end face of the main body 22, in present case from the second end face 27 of the main body 22, outwards in axial direction parallel to the main axis A beyond the end face 27. The lip 28 is arranged in a distance to both the inner side 24 and the outer side 23 of the main body 22. In the preferred embodiment shown, the lip 22 is arranged in the middle of the radial extension of the main body 22, thereby giving the sealing gasket 2 a generally T-shaped configuration. The lip 22 extends as a complete ring over the entire circumference of the main body 22 so as to be closed within itself. In alternative embodiments, the lip 22 may also be segmented in the circumferential direction instead of forming a continuous annular ring.

Referring again to figure 1, it may be seen that the fixation lip 28 is received in the fixation groove 21 in the assembly face 13 of the component 4. The lip 28 is positioned in a press-fit in the fixation groove 21 so as to be slightly compressed and firmly held therein.

With particular reference to figure 2b, it may be seen that the lip 28 comprises a rounded head 29 and a connecting portion 31 connecting the head 29 to the main body 22. The connecting portion 31 has a width W_{CP} in a radial direction perpendicular to the main axis A that is smaller than the corresponding width W_{H} of the head 29. The width W_{H} of the head 29 is slightly smaller than the width of the fixation groove 21 to ensure that the rounded head 29 may be slightly compressed by the flank surfaces of the fixation groove 21. Preferably, a substantially linear pressure contact may be established between the rounded head 29 and the flank surfaces of the fixation groove 21. This substantially linear contact may provide a high contact pressure for improved sealing performance at the head 29 preventing gas from passing or leaking around the head 29.

In preferred embodiments of the present invention, the lip 22 is integrally formed, that is, formed in one piece, with the main body 22 and is made of the same elastomeric material as the main body 22. Preferably, the entire gasket 2 with the main body 22 and the fixation lip 28 may be produced in the same manufacturing process, e.g. by injection of a non-vulcanized or uncured elastomeric material into a mold, followed by a compression and a curing step, if desired or required. Suitable elastomeric materials are mentioned above in connection with the main body 22.

The sealing system 1 configured in the manner described above may be handled and operated as follows:
In order to seal an apparatus, in particular a medium or high voltage apparatus containing an insulating gas, the gasket 2 is placed between the assembly faces 12, 13 of the two components 3, 4, e.g. in the respective recesses 18, 19, wherein at the same time the fixation lip 28 is inserted into the fixation groove 21 in the assembly face 13. The reduced width W_{CP} of the connecting portion 31 compared to the width W_{H} of the head 29 together with a sufficient length of the lip 28 provide some flexibility and facilitate insertion of the lip 28 into the fixation groove 21. The height H of the lip 28 in the axial direction is preferably greater than the thickness T of the main body 22 and may preferably be at least 1.5 times the axial thickness T of the main body 22. The lip 28 is received with only slight compression between the flank surfaces of the fixation groove 21 in order not to hinder the introduction but to be held securely therein.

The gasket 2 may be assembled with a small film of grease to ensure a tight fit of the gasket 2 and prevent tearing, cutting, crushing and ablation of the elastomeric gasket. The grease may reduce the effort required to assemble the gasket and also serves in conventional sealing systems to prevent the gasket from moving. In view of the provision of the fixation lip 28, the amount of grease may substantially be reduced or the sealing gasket 2 may even be used without grease. This may reduce if not avoid the risk of crystallization of grease at low temperatures and make the gasket 2 suitable for applications requiring very low temperatures of up to -50°C, for example. The assembly effort and costs may be significantly reduced.

Once the gasket 2 is properly positioned and fixed using the fixation lip 28, the tightening means 14 may be tightened to firmly fasten the components 3, 4 together and compress the gasket 2 to the desired and required degree. Then, the apparatus may be filled with the desired gas. In preferred embodiments of the invention, in the operating state of the gasket, the main body 22 may have an average compression rate comprised between 10% and 30%, preferably between 15% and 25%. Such an average compression rate has proven optimum to reduce the gas permeation to the minimum while ensuring integrity and durability of the gasket 2 over a long period of time.

The average compression rate of the main body 22 is higher than the average compression rate of the lip 28 in the fixation groove 21, since the linear contact of the rounded head 29 with the flank surfaces of the fixation groove 21 suffices to prevent leakage around the lip 28.

The flat planar configuration of the main body 22 of the inventive gasket 2 in combination with the specific average compression provide a high level of tightness of the gasket 2. The compressed main body 22 has a relatively great length and reduced surface area under gas pressure, which is exposed to the gas, such that the diffusion or permeation of the gas can be greatly reduced. The ratio of the length L of the main body 22 in the radial direction to the thickness T in the axial direction may be at least 5 or preferably at least 7 or, most preferably, approximately 8-12.

In the preferred embodiment shown, the ratio of the length L to the thickness T is approximately 10. The thickness T is approximately 3 mm, the height H of the lip 28 is approximately 5 mm, the width W_{CP} of the connecting portion is approximately 4 mm and the width W_{H} of the head 29 is approximately 5 mm. The inner diameter of the gasket 2 in the preferred embodiment shown is approximately 200 mm, and the outer diameter is approximately 260 mm.

The dimensions of the gaskets and its portions may be selected depending on the desires and requirements of the respective application. The gasket 2 according to the invention can be made relatively large, e.g. with an inner dimension or inner diameter that can, for example, be comprised between 40 mm or 55 mm or 100 mm on the one hand and, on the other hand, 500 mm or even 1300 mm. Such large gaskets are more critical in terms of tightness than the usually used smaller gaskets having a diameter of less than 40 mm, for example.

Even for such large gaskets, the fixation lip 28 ensures stable retention of the gasket 2 in the respective operating position, whether it is a vertical or horizontal position or another orientation. Conventionally, high vibrations of the apparatus and high pressure of the insulating gas contained inside the apparatus may lead to movement and displacement of a sealing gasket. In the inventive structure, the lip 28 engaged in the fixation groove 21 reliably prevents the gasket 2 from being moved or displaced during operation, although the gasket 2 is directly exposed to the internal gas pressure.

Tests with the sealing system 1 of the invention have shown that for the above-mentioned applications, gas types and gas pressures, the sealing system 1 of the present invention is able to greatly improve the tightness of the apparatus and provide a leakage rate that is less than 0.5% vol/year, thereby meeting the requirements of relevant IEC standards, e.g. the standard IEC 62271-203 for gas-insulated switchgears.

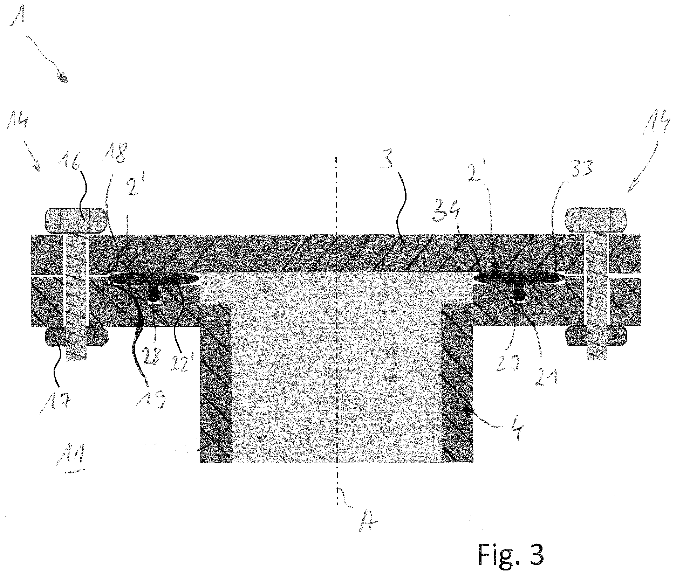

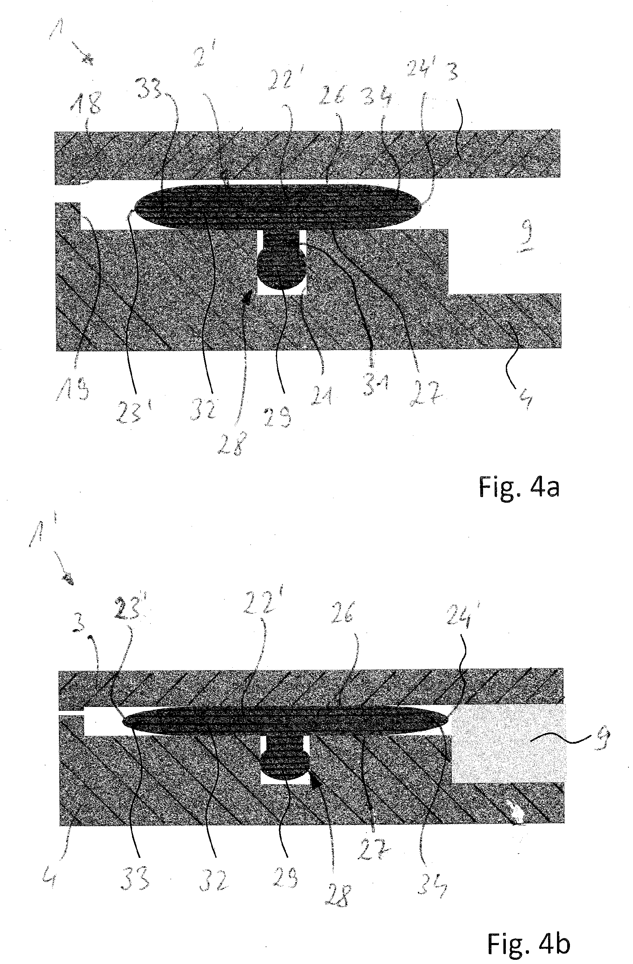

Figures 3, 4a and 4b show another embodiment of a sealing system 1 according to the invention. To the extent that there is an agreement in construction and/or function with the above-explained first embodiment of the sealing system 1 and the compression sealing gasket 2 according to figures 1, 2a and 2b, reference is made to the above description using the same reference numerals.

The second embodiment of the sealing system 1 according to figures 3, 4a and 4b only differs from the first embodiment according to figures 1, 2a and 2b in the shape of the gasket 2', and in particular the shape of the main body 22' of the gasket 2'. In contrast to the gasket 2, the radially outer and inner sides 23', 24' of the main body 22' of the gasket 2' are not planar and parallel to each other, but are rounded or convexly curved. In particular, the outer and inner sides 23', 24' may be oval-shaped. This configuration allows to reduce the compression pressure at the radial ends of the gasket 2' during operation and also facilitates expansion of the gasket 2' in the radial direction in reaction to a compression and/or a thermal expansion. In addition, the form of the gasket 2' reduces material and manufacturing costs.

As may be seen from figures 4a and 4b, the main body 22' of the gasket 2' may comprise a central portion 32 delimited by substantially planar end faces 26, 27 and tapering end portions 33, 34, which are substantially half circle or half oval in shape and are delimited by the rounded radially outer and inner sides 23', 24'. In the uncompressed state shown in figure 4a, the thickness T of the main body 22' in the central portion 32 is substantially larger than its thickness in the compressed state shown in figure 4b. As mentioned above, the average compression rate is comprised between 10% and 30% and preferably between 15% and 25%.

When the gasket 2' is compressed, the configuration of the end portions 33, 34 facilitates expansion of the gasket 2' in both radial directions. Sufficient clearance is provided between the radially outer and inner sides 23', 24' of the gasket 2' on the one hand and, on the other hand, the opposite flank surfaces of the recesses 18, 19 or the interior space of the apparatus such that, as a result of the compression between the assembly faces 12, 13 of the components 3, 4, the end portion 33 may readily expand in the radially outer direction, while the end portion 34 may readily expand in the radially inner direction.

A comparison of figures 4a and 4b shows that the length of the main body 22' of the gasket 2' may thus be greatly increased in the compressed state. Advantageously, this greatly reduces the surface area under pressure, which is exposed to the gas, and substantially increases the length of the gasket 2', in particular the main body 22', thereby minimizing the permeation or diffusion of the gas through the main body 22'. The gasket 2' is capable of providing a very gastight connection between the components 3, 4 with a very low leakage rate of insulating gases in gas-insulated high or medium voltage apparatuses.

In addition, the low compression zones in the end portions 33, 34 of the main body 22' greatly reduce tear and wear at these locations, which are normally prone to tear and wear under compression. In combination with the reduced leakage rate of the insulating gas, this may enable longer durability of the gasket 2' and extended service intervals of the apparatus.

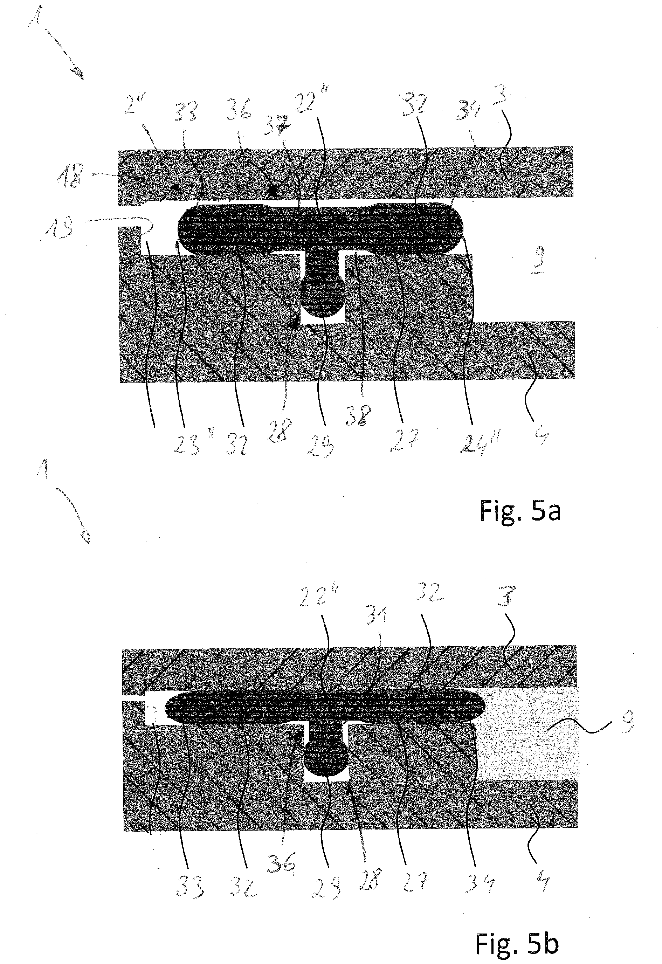

Figures 5a and 5b show a third embodiment of the sealing system 1 according to the invention. Again, to the extent that there is an agreement in construction and/or function with the above-explained first or second embodiments according to figures 1-4b, reference is made to the above description using the same reference numerals.

The embodiment of the sealing system 1 according to figures 5a and 5b corresponds to the second embodiment shown in figures 3, 4a and 4b in that the main body 22" of the gasket 2" also includes convexly curved, circular or oval-shaped outer and inner sides 23", 24" defining tapering, half-circular or oval-shaped end portions 33, 34. In contrast to the second embodiment, the main body 22' of the gasket 2" of the third embodiment of figures 5a and 5b further comprises a cross-sectional constriction 36 in the central portion 32 approximately in the middle or center of the planar extension of the main body 22" in the radial direction perpendicular to the main axis A. The cross-sectional constriction 36 may be formed by depressions 37, 38 formed in the end faces 26, 27 in the middle of the central portion 32.

The regions of the main body 22" between the cross-sectional constriction 36 and the end portions 33, 34 have planar end faces 26, 27, but, in alternative embodiments, the end faces 26, 27 in these regions might also be convexly curved or wavy-shaped. In any case, the cross-sectional constriction 36 in combination with the tapering end portions 33, 34 allow to create, in the operating state of the compression sealing gasket 2", low gasket compression zones in the middle of the central portion 32 of the gasket 2" and at the end portions 33, 34, thereby reducing the loading and corresponding tear, wear and risk of damage in these portions. The loading on the fixation lip 28 may also be reduced by the cross-sectional constriction 36. In addition, high gasket compression zones are created in the regions between the cross-sectional constriction 36 and the end portions 33, 34 to thereby achieve an efficient tightness and low leakage rate.

A compression sealing gasket 2, 2', 2" and a sealing system 1 of a gas-insulated portion of a high or medium voltage apparatus are disclosed. The sealing system 1 comprises two components 3, 4 fastened together, wherein each of the components 3, 4 comprises an assembly face 12, 13 that faces the assembly face 13, 12 of the other component 4, 3, and a compression sealing gasket 2, 2', 2" that is arranged and compressed axially between the assembly faces 12, 13 of the components 3, 4. The compression sealing gasket 2, 2', 2" comprises a ring-shaped, preferably annular main body 22, 22', 22" made of an elastomer material and having a main axis A. The main body 22, 22', 22" has a generally flat planar configuration that extends perpendicular to the main axis A and comprises a radially outer side 23, 23', 23", a radially inner side 24, 24', 24" and end faces 26, 27 which delimit the main body 22, 22', 22" along the main axis A and connect the inner side 24, 24', 24" and the outer side 23, 23', 23". The gasket 2, 2', 2" further comprises a lip 28 projecting from the main body 22, 22', 22" outwards in axial direction parallel to the main axis A beyond one of the end faces 26, 27. The lip 28 is arranged in a distance to both the inner side 24, 24', 24" and the outer side 23, 23', 23" of the main body 22, 22', 22" and engages a ring-shaped fixation groove 21 formed in an assembly face 12, 13 of one of the components 3, 4. The fixation groove 21 receives the lip 28 of the gasket 2, 2', 2" with slight compression, thereby preventing movement or displacement of the gasket 2, 2', 2" during operation.

## Claims

1. A compression sealing gasket (2, 2', 2") comprising:
a ring-shaped main body (22, 22', 22") made of an elastomer material and having a main axis (A), the main body (22, 22', 22") having a generally planar configuration that extends perpendicular to the main axis (A) and comprising a radially outer side (23, 23', 23"), a radially inner side (24, 24', 24") and end faces (26, 27) which delimit the main body (22, 22', 22") along the main axis (A) and connect the inner side (24, 24', 24") and the outer side (23, 23', 23"); and
a lip (28) projecting from the main body (22, 22', 22") in axial direction parallel to the main axis (A) beyond one of the end faces (26, 27), the lip (28) arranged in a distance to both the inner side (24, 24', 24") and the outer side (23, 23', 23") of the main body (22, 22', 22").

2. The gasket (2, 2', 2") according to claim 1, wherein the main body (22, 22', 22") has an annular or oval or ellipsoidal shape in a plane perpendicular to the main axis (A) .

3. The gasket (2, 2', 2") according to claim 1 or 2, wherein the main body (22, 22', 22") has a generally rectangular cross-section in an axial plane including the main axis (A).

4. The gasket (2, 2', 2") according to anyone of the preceding claims, wherein the outer side (23, 23', 23") and the inner side (24, 24', 24") each have a tapering shape and/or the end faces (26, 27) have a convexly curved or wavy shape at least in a section thereof.

5. The gasket (2, 2', 2") according to anyone of the preceding claims, wherein the main body (22, 22', 22") has a cross-sectional constriction (36) approximately in the middle of its planar extension in the radial direction perpendicular to the main axis (A).

6. The gasket (2, 2', 2") according to anyone of the preceding claims, wherein the lip (28) is arranged in the middle of the radial extension of the main body (22, 22', 22") and extends as a complete ring over the entire circumference of the main body (22, 22', 22").

7. The gasket (2, 2', 2") according to anyone of the preceding claims, wherein the lip (28) is integrally formed with the main body (22, 22', 22") and is made of the same material as the main body (22, 22', 22").

8. The gasket (2, 2', 2") according to anyone of the preceding claims, wherein the lip (28) comprises a rounded head (29) and a connecting portion (31) connecting the head (29) to the main body (22, 22', 22"), the connecting portion (31) preferably having a width (W_{CP}) in a radial direction perpendicular to the main axis (A) that is smaller than the corresponding width (W_{H}) of the head (29).

9. The gasket (2, 2', 2") according to anyone of the preceding claims, wherein the main body (22, 22', 22") has a ratio of its length (L) in the radial direction perpendicular to the main axis (A) to its thickness (T) in the axial direction, wherein the ratio is at least 5 or preferably at least 7 or most preferably 8-12.

10. The gasket (2, 2', 2") according to claim 9, wherein the height (H) of the lip (28) in the axial direction is greater than the thickness (T) of the main body (22, 22', 22"), preferably at least 1.5 times as great as the thickness (T) of the main body (22, 22', 22").

11. A sealing system (1) of a gas-insulated portion of a high or medium voltage apparatus, comprising:
two components (3, 4) fastened together, wherein each of the components (3, 4) comprises an assembly face (12, 13) that faces the assembly face (13, 12) of the other component (4, 3); and
a compression sealing gasket (2, 2', 2") according to anyone of the preceding claims, wherein the gasket (2, 2', 2") is arranged and is compressed axially between the assembly faces (12, 13) of the components (3, 4).

12. The sealing system (1) according to claim 11, wherein at least one of the assembly faces (12, 13) comprises a recess (18, 19) in which the compression sealing gasket (2, 2', 2") is located.

13. The sealing system (1) according to claim 11 or 12, wherein one of the assembly faces (12, 13) comprises a ring-shaped fixation groove (21) arranged to receive the lip (28) of the gasket (2, 2', 2") with slight compression in the radial direction perpendicular to the main axis (A).

14. The sealing system (1) according to anyone of claims 11 to 13, wherein, in the operating state of the gasket (2, 2', 2"), the main body (22, 22', 22") has an average compression rate comprised between 10% and 30%, preferably between 15% and 25%, the average compression rate of the main body (22, 22', 22") being higher than the average compression rate of the lip (28).

15. The sealing system (1) according to anyone of claims 11 to 14, wherein the gas insulated portion forms part of a gas-insulated switch, circuit-breaker, disconnector, transformer, surge arrester, a gas-insulated substation or a gas-insulated line; and/or
wherein the gas-insulated portion contains a gas comprising at least one of:
- SF₆ gas,
- heptafluoroisobutyronitrile and/or heptafluoroisopropyl trifluoromethyl ketone (also named 2-butanone, 1,1,1,3,4,4,4-heptafluoro-3-(trifluoromethyl)- (CAS No 756-12-7)), possibly mixed with a gas or a dilution gas comprising at least CO₂ and/O₂ and/or N₂ and/or an oxygenated compound, and
- a gas comprising at least CO₂ and/or O₂ and/or N₂ and/or an oxygenated compound and/or water vapor; and/or
wherein the gas is contained in the apparatus at a pressure between 1 bar and 20 bar, preferably between 5 bar or 15 bar.
